# EUROPEAN PATENT APPLICATION

(11) **EP 4 776 516 A1**
(43) Date of publication of application: **15.07.2026**
(21) Application number: 26151336.0
(22) Date of filing: 12.01.2026
(51) Int. Cl.: H03M 1/12

(54) **MULTI-MODE INSTRUCTION OPERATION OF ANALOG-TO-DIGITAL CONVERTER**

(30) Priority: 13.01.2025 US 202519018383
(71) Applicant: Avago Technologies International Sales Pte. Limited, Singapore 768923 (SG)
(72) Inventor: Khanpour, Mehdi, Newport Beach, 92660 (US); Vakilian, Kambiz, Irvine, 92603 (US); Liu, Feifei, Irvine, 92618 (US); Samavati, Behzad, Santa Ana, 92706 (US); Jara Toro, Matias Ignacio, Irvine, 92618 (US)
(74) Representative: Dilg, Haeusler, Schindelmann Patentanwaltsgesellschaft mbH

(57) **Abstract**

An apparatus including first and second samplers, first and second analog-to-digital converters, and a clock generator. The first sampler produces a first stream of sampled values in response to sampling an analog input signal on a first input channel. The first analog-to-digital converter generates a first stream of digital data. The second sampler produces a second stream of sampled values in response to sampling an analog input signal on a second input channel. The second analog-to-digital converter converts the second stream of sampled values into a second stream of digital data. The clock generator causes the first analog-to-digital converter to convert the first stream of sampled values into the first stream of digital data in response to a mode instruction designating a custom operating mode. The clock generator also causes the first analog-to-digital converter to convert the second stream of sampled values into the first stream of digital data in response to the mode instruction designating a standard operating mode.

## Description

### BACKGROUND

In electronics, an analog-to-digital converter (ADC) is an electronic device or circuit that is designed to convert an analog signal into digital data. High-speed interleaved ADCs are commonly used in applications requiring high-speed data acquisition where processing high-bandwidth signals is critical.

### BRIEF DESCRIPTION OF DRAWINGS

The accompanying drawings, which are incorporated in and form a part of this specification, illustrate examples of the disclosure and, together with the description, explain principles of the examples.
FIG. 1 illustrates an exemplary device, in accordance with one or more embodiments of the disclosure.
FIG. 2A illustrates an exemplary analog-to-digital converter array, in accordance with one or more embodiments of the disclosure.
FIG. 2B illustrates an exemplary Time-Interleaved Analog-to-Digital Converter, in accordance with one or more embodiments of the disclosure.
FIGS. 3A-3B illustrate an exemplary single-channel operational mode, in accordance with one or more embodiments of the disclosure.
FIGS. 4A-4B illustrate an exemplary dual-channel operational mode, in accordance with one or more embodiments of the disclosure.
FIGS. 5A-5B illustrate an exemplary quad-channel operational mode, in accordance with one or more embodiments of the disclosure.

In the drawings, like reference symbols and numerals indicate the same or similar components. Like elements in the various figures are denoted by like reference symbols and numerals for consistency. Unless otherwise indicated, like elements and method steps are referred to with like reference numerals.

### DETAILED DESCRIPTION OF THE INVENTION

The following describes technical solutions in this specification with reference to the accompanying drawings. Exemplary embodiments are described in detail with reference to the accompanying drawings.

A high-speed interleaved ADC is a type of analog-to-digital converter that uses multiple ADCs (sub-ADCs) operating in parallel to achieve higher effective sampling rates than a single ADC can provide. In this configuration, an analog signal is distributed among the sub-ADCs, with each one sampling at a staggered time interval, effectively interleaving their operation. The sampled data from all sub-ADCs are then combined to form a single high-rate digital output. This configuration allows the high-speed interleaved ADC to achieve a total sampling rate equal to the individual sampling rates of the sub-ADCs multiplied by their number.

While interleaving enables higher performance, it introduces challenges. For example, the number of interleaved sub-ADCs driven by a sample-and-hold (S&H) circuit is fixed and essentially "hard-wired." As a result, the sampling rate can only be decreased, leading to inefficient utilization of the sub-ADCs and a reduction in total ADC throughput. This limitation is particularly problematic in scenarios where configurable sampling rates and dynamic channel allocation are necessary to accommodate diverse application requirements. The inability to adjust the number of active sub-ADCs restricts the system's flexibility and efficiency, making it less suitable for applications demanding adaptable data acquisition solutions. Accordingly, there is a need in the art for a configurable sampling front-end that enables sampling on multiple input channels at adjustable sampling rates.

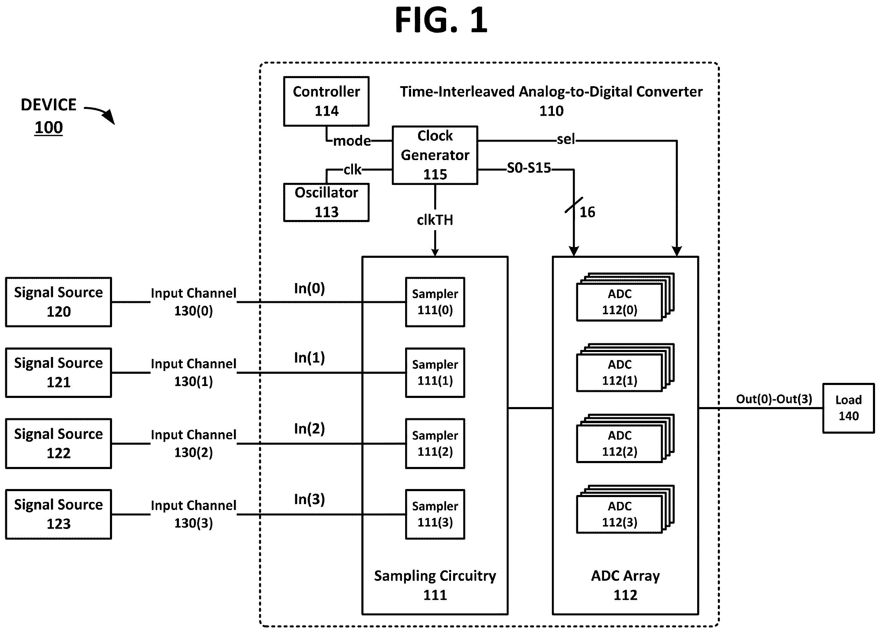

Referring to FIG. 1, device 100 is illustrated. Device 100 may include Time-Interleaved Analog-to-Digital Converter (TI-ADC) 110, signal sources 120-123, input channels 130(0)-130(3) and load 140. TI-ADC 110 may include sampling circuitry 111, analog-to-digital converter (ADC) array 112, oscillator 113, controller 114 and clock generator 115.

Sampling circuitry 111 may include samplers 111(0)-111(3). Samplers 111(0)-111(3) may receive analog input signals In(0)-In(3) from signal sources 120-123. By way of example, sampler 111(0) may receive analog input signal In(0) from signal source 120 via input channel 130(0). Sampler 111(1) may receive analog input signal In(1) from signal source 121 via input channel 130(1). Sampler 111(2) may receive analog input signal In(2) from signal source 122 via input channel 130(2). Sampler 111(3) may receive analog input signal In(3) from signal source 123 via input channel 130(3).

Any one of the analog input signals In(0)-In(3) may be individually referred to as "analog input signal." A plurality of analog input signals In(0)-In(3) may be collectively referred to as "analog input signals." Although four analog input signals are illustrated, those skilled in the art will appreciate that any number of analog input signals other than four analog input signals may exist in device 100.

Any one of the input channels 130(0)-130(3) may be individually referred to as "input channel." A plurality of input channels 130(0)-130(3) may be collectively referred to as "input channels." Although four input channels are illustrated, those skilled in the art will appreciate that any number of input channels other than four input channels may exist in device 100.

Signal sources 120-123 are separate and distinct components. Each of the signal sources 120-123 is an electrically powered device capable of individually supplying analog input signals to TI-ADC 110.

Examples for signal sources 120-123 may include a sensor, a transducer and/or any other component that converts physical phenomena into an electrical signal. Other examples of signal sources 120-123 may include a function generator, a waveform generator and/or any other component used in testing and measurement. In some implementations, signal sources 120-123 may include a communication system. In other implementations, signal sources 120-123 may include an ECG monitor, an EEG monitor and/or any other biomedical device. Signal sources 120-123 may include audio equipment and/or any video equipment.

For instance, signal sources 120-123 may each be configured as a mobile communication device including, but not limited to, a mobile phone, a smart phone, cell phone, or tablet. Signal sources 120-123 may each be configured as a wearable device, a smartwatch, a fitness tracker or a personal digital assistant (PDA). In other examples, signal sources 120-123 may each be configured as a media device (e.g., media playing and/or recording device). For instance, signal sources 120-123 may include portable music player, an audio device such as an audio recorder, an audio converter, an audio player, or a speaker (e.g., a Bluetooth-enabled speaker). In other instances, signal sources 120-123 may include a video device such as a video display, a video recorder, a camera, or other video device. In another example, signal sources 120-123 may each be configured as, a driver assistance module in a vehicle, a light detection and ranging (LiDAR) sensor, an emergency transponder, a pager, a watch, a satellite television receiver, a stereo receiver, a computer system, music player, laptop or tablet computer, home appliance, or virtually any other device. In another example, signal sources 120-123 may each be configured as a computer (e.g., a laptop computer). In other examples, signal sources 120-123 may each be configured as a computing/entertainment device for a vehicle.

In some implementations, signal source 120 may exist as a function generator; signal source 121 may exist as a communication system; signal source 122 may exist as audio equipment; signal source 122 may exist as a sensor. Those skilled in the art will appreciate that signal sources 120-123 are not limited to the examples presented herein.

Load 140 may be any circuit, device, or system that receives and processes digital outputs Out(0)-Out(3) produced by TI-ADC 110. Any one of the digital outputs Out(0)-Out(3) may be individually referred to as "digital output." A plurality of digital outputs Out(0)-Out(3) may be collectively referred to as "digital outputs." Although four digital outputs are illustrated, those skilled in the art will appreciate that any number of digital outputs other than four digital outputs may exist in device 100.

Examples of load 140 may include, but not limited to, a processor, a digital signal processors (DSP), a microprocessor, a microcontroller and/or any circuitry that process digitized data. In some configurations, load 140 may be a Field-Programmable Gate Array (FPGA) and/or any circuitry that manages high-speed or parallel data processing. In other configurations, load 140 may be a memory device. Load 140 may be a Serial Peripheral Interface (SPI), an Inter-Integrated Circuit (I²C), a Universal Asynchronous Receiver-Transmitter (UART) and/or any communication interface. Load 140 may include an actuator, a display, test equipment and/or any other electronic component. Those skilled in the art will appreciate that load 140 is not limited to the examples presented herein.

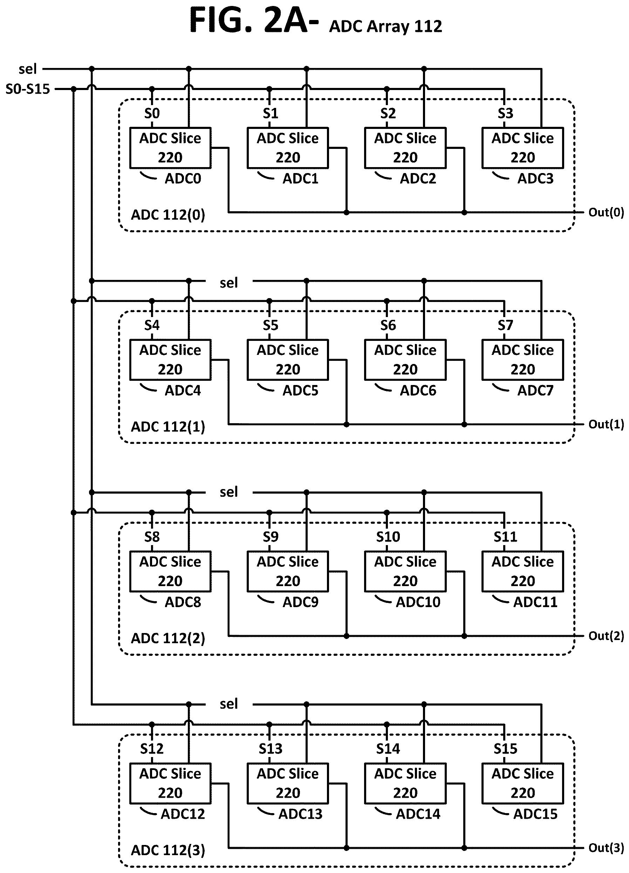

Turning now to FIG. 2A, an example ADC array 112 is illustrated. By way of illustration, identical ADC slices 220 in analog-to-digital converter ADC 112(0) may include slices ADC0-ADC3. Identical ADC slices 220 in analog-to-digital converter ADC 112(1) may include slices ADC4-ADC7. Identical ADC slices 220 in analog-to-digital converter ADC 112(2) may include slices ADC8-ADC11. Identical ADC slices 220 in analog-to-digital converter ADC 112(3) may include slices ADC12-ADC15.

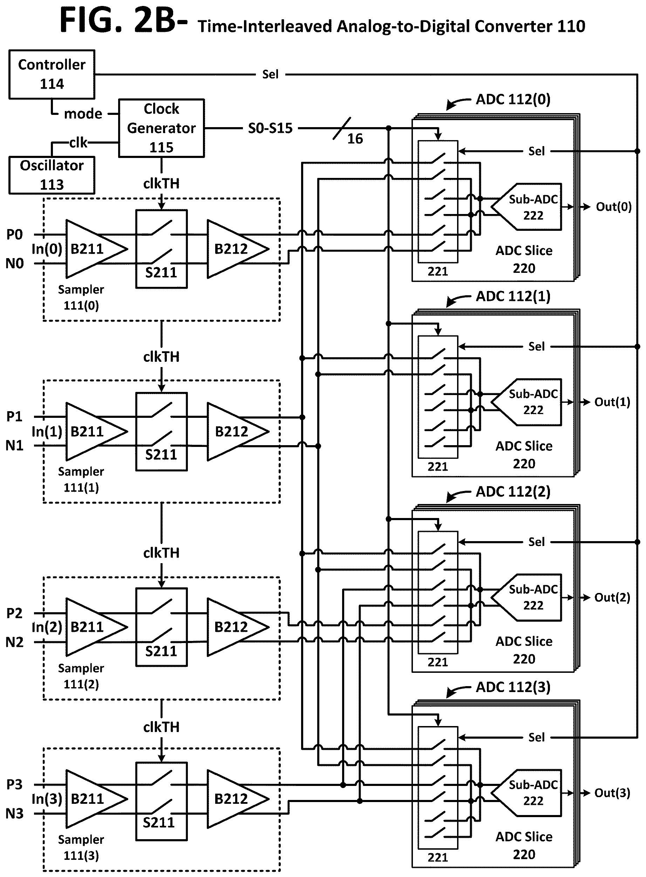

Referring to FIG. 2B, an exemplary TI-ADC 110 is illustrated. TI-ADC 110 may include samplers 111(0)-111(3), analog-to-digital converters ADCs 112(0)-112(3), oscillator 113, controller 114 and clock generator 115.

Any one of the samplers 111(0)-111(3) may be individually referred to as "sampler 111(i)." A plurality of samplers 111(0)-111(3) may be collectively referred to as "samplers 111(i)." Similarly, those skilled in the art will appreciate that any number of samplers 111(i) other than four samplers 111(i) may exist in TI-ADC 110 although four samplers 111(i) are illustrated. Sampler 111(i) is electronic hardware that may capture a continuous analog input signal and convert the analog input signal into a stream of sampled values. Referred to herein, a "stream of sampled values" is a series of discrete-time samples of the analog input signal.

Sampler 111(i) may continuously monitor and capture real-time variations of the analog input signal to track the analog input signal present on an input channel. For instance, sampler 111(i) may hold the analog input signal on the input channel by first tracking the signal's real-time variations during the sampling phase and then stabilizing (or "holding") the instantaneous value of the analog input signal during the hold phase. The hold phase ensures that the analog input signal remains constant and unchanging while a sampled value is processed or converted to a digital word. For example, when the input channel carries a time-varying analog input signal, sampler 111(i) may capture the analog input signal at precise intervals and freezes the analog input signal momentarily to produce discrete sampled values. These discrete sampled values form a stream of samples that accurately represent the analog input signal over time, enabling further digital processing or analysis while preserving the integrity of the analog input signal.

Sampler 111(i) may include switch S211 and buffers B211, B212. Buffer B211 is a component that may provide, at its input, a high input impedance that reduces loading on a source of the analog input signal to ensure minimal current draw from the signal source to avoid loading effects when buffer B211 receives the analog input signal. The high input impedance at the input of buffer B211 may minimize loading on the source of the analog input signal by ensuring that a negligible amount of current is drawn from the source. At its output, buffer B211 may provide a low output impedance. The low output impedance may ensure stable delivery of the analog input signal to switch S211 with minimal distortion and resistance. By preserving the fidelity of an analog input signal, buffer B211 may ensure that sampled values of the analog input signal accurately represent the original analog input signal, enhancing the overall performance of the analog-to-digital conversion process.

In some implementations, the analog input signal may happen to be a differential signal. As a differential signal, the analog input signal may provide enhanced accuracy and noise rejection. The differential signal may consist of two complementary voltages, typically referred to as positive input (P) and negative input (N). Positive input (P) and negative input (N) may happen to be voltages equal in magnitude but opposite in polarity with respect to a common reference, such as ground. By illustration, differential analog input signal In(0) may include positive input P0 and negative input N0; differential analog input signal In(1) may include positive input P1 and negative input N1; differential analog input signal In(2) may include positive input P2 and negative input N2; and differential analog input signal In(3) may include positive input P3 and negative input N3. In the form of a differential signal, an analog input signal may minimize common-mode noise and interference, ensuring that sampler 111(i) processes only the true differential component, which carries the essential information of the differential analog input signal.

Switch S211 is a component that may toggle between two operational phases: tracking and holding. During the tracking phase, switch S211 remains closed, allowing the analog input signal to flow from buffer B211 to buffer B212 through switch S211. When closed, switch S211 may allow the continuous flow of the analog input signal, enabling buffer B212 to capture real-time variations of the analog input signal. During the holding phase, switch S211 remains opened and isolates buffer B212 from buffer B211. Isolating buffer B212 from buffer B211 in effect "freezes" the analog input signal at its current value, preserving the analog input signal for further processing.

ADC array 112 may include ADCs 112(0)-112(3). In some implementations, ADCs 112(0)-112(3) may each be an analog-to-digital converter. In other implementations, ADCs 112(0)-112(3) may each be interleaved analog-to-digital converters. Any one of the analog-to-digital converters ADCS 112(0)-112(3) may be individually referred to as "ADC 112(i)." A plurality of the analog-to-digital converters ADCS 112(0)-112(3) may be collectively referred to as "ADCs 112(i)." Although four ADCs 112(i) are illustrated, those skilled in the art will appreciate that any number of ADCs 112(i) other than four ADCs 112(i) may exist in TI-ADC 110.

ADC 112(i) is electronic hardware that may convert the streams of sampled values into discrete streams of digital data. Referred to herein, a "stream of digital data" is a continuous, time-ordered flow of data that ADC 112(i) may process and/or transmit in real-time. Buffer B212 may provide impedance matching between switch S211 and ADC 112(i). In some instances, buffer B212 may function as a level shifter when a voltage range associated with the sampled values differs from an input requirement for ADC 112(i).

ADC 112(i) may include one or more ADC slices 220. ADC slice 220 is a modular subunit within ADC 112(i). Each ADC slice 220 is designed to process portions of an input signal in parallel with other ADC slices 220 to achieve higher resolution, faster sampling rates, or both. Each ADC slice 220 may function as an independent ADC core. Referred to herein, an ADC core is circuitry that may perform a conversion of the sampled values into a digital output.

Multiplexer 221 is an electronic component that may allow streams of sampled values to share a single ADC 112(i). For instance, multiplexer 221 is designed to select between the stream of sampled values from one or more of the ADCs 112(i) and route the sampled values of the stream to sub-ADC 222 for conversion into the digital data. Multiplexer 221 may enable a single ADC 112(i) to process streams of sampled values from one or more samplers 111(i), resulting in a cost-effective and space-efficient design for TI-ADC 110. In particular, multiplexer 221 may allow a single ADC 112(i) to process a stream of sampled values from a single sampler 111(i). By combining multiplexer 221 with sub-ADC 222, ADC 112(i) may efficiently manage the sampled values while providing accurate conversions of the sampled values into the digital data.

Oscillator 113 may exist as an electronic component that is responsible for generating a stable and precise reference clock (clk). Referred to herein, reference clock (clk) may be any periodic waveform. A periodic waveform is a signal that repeats itself at regular intervals over time. Specifically, each cycle of the periodic waveform is a complete repetition of the signal that takes the same amount of time. Those skilled in the art will appreciate that reference clock (clk) may exist in the form of a rectangular wave, a sine wave, a triangle wave, a sawtooth wave and/or any other periodic waveform.

Controller 114 is electronic hardware implemented as any suitable processing circuitry. The processing circuitry may include, but not limited to, at least one of a microcontroller, a microprocessor, a single processor, and a multiprocessor. Controller 114 may include at least one of an embedded controller (EC), a central processing unit (CPU), an accelerated processing unit (APU), an application specific integrated circuit (ASIC), a field programmable gate array (FPGA), a complex programmable logic device (CPLD), logic circuitry, a state machine, a programmable processor, or the like. Controller 114 may be implemented as electronic hardware that may include digital circuits, analog circuits or a combination of both digital and analog circuits. Analog circuits may include analog components that are suitable to process analog gate signals. Digital circuits may include switches and gates that are suitable to process digital gate signals.

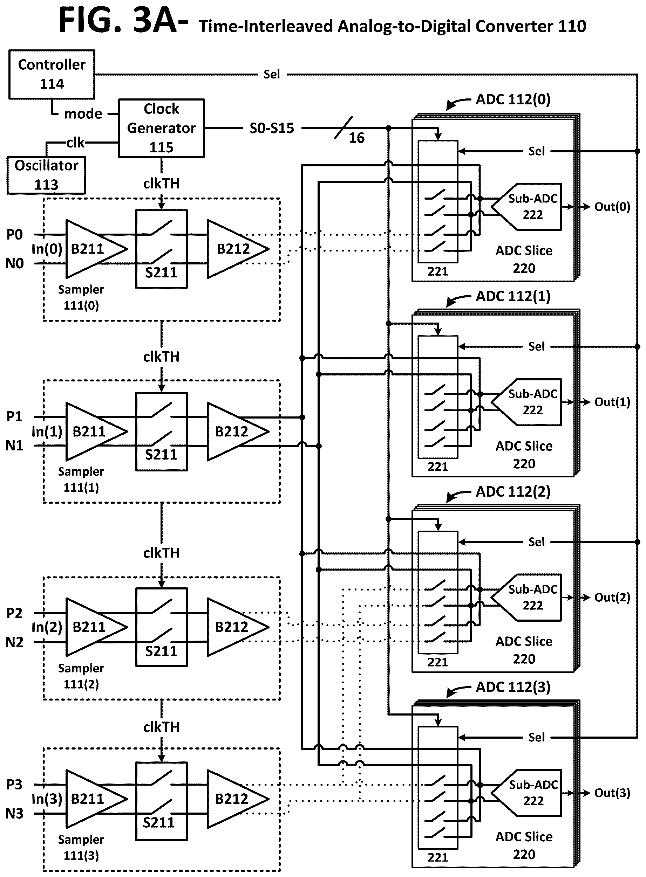

Clock generator 115 may govern the overall timing of TI-ADC 110, as illustrated by the examples of FIGS. 3A-5B. Implemented as electronic hardware, clock generator 115 may include digital circuits, analog circuits or a combination of both digital and analog circuits. Analog circuits may include analog components that are suitable to process analog gate signals. Digital circuits may include switches and gates that are suitable to process digital gate signals.

FIGS. 3A-5B illustrate flexible and configurable implementations of TI-ADC 110. In some instances, a plurality of ADC slices 220 may operate in a time-interleaved configuration, sampling the sampled values at staggered intervals to multiply the effective sampling rate. In other instances, the plurality of ADC slices 220 may process different segments of the sampled values to improve throughput. Parallel processing may improve power efficiency, as each ADC slice 220 may operate at a lower clock speed and power level compared to a monolithic ADC. ADC slice 220 may each include multiplexer 221 and sub-ADC 222 to allow for the conversion of the sampled values into the digital data.

In governing the switching of sampler 111(i) and ADC 112(i), clock generator 115 may receive a mode instruction from controller 114. The mode instruction is a command that may provide operational parameters for clock generator 115. For example, clock generator 115 may extract user-customizable timing information from the operational parameters. In the timing information, a user may specify the sample rate for TI-ADC 110. Referred to herein, the sampling rate is defined as the frequency at which sampler 111(i) captures and holds discrete instantaneous sampled values, enabling subsequent processing of sampled values by ADC 112(i).

Sampling clock (clkTH) is sourced from reference clock (clk). For instance, clock generator 115 may receive reference clock (clk) from oscillator 113 and generate sampling clock (clkTH) from reference clock (clk). In some implementations, clock generator 115 may perform division of reference clock (clk) to generate sampling clock (clkTH).

Clock generator 115 may extract user-customizable selection information from the operational parameters. In the selection information, the user may designate the input channels that are active. Referred to herein, a "single-channel operational mode" is a configuration in which only one input channel 130 is designated in the selection information as an active input channel. A standard operating mode is the single-channel operational mode. An "active input channel" is referred to herein as an input channel that may receive an analog input signal from a signal source. The distinction between an "active input channel" and an "inactive input channel" lies in their operational state and functionality within TI-ADC 110. In contrast with an active input channel, an "inactive input channel" is referred to herein as an input channel that is disabled or idle, having no role in the operation of TI-ADC 110.

FIGS. 3A-3B illustrate an implementation of a single-channel operational mode. The selection information may designate only input channel 130(1) as an active input channel for the single-channel operational mode. Sampler 111(1) may receive analog input signal In(1) from signal source 121 via input channel 130(1) in FIGS. 3A-3B.

In the example of FIG. 3A, clock generator 115 may output selection signaling (sel) that causes multiplexer 221 in ADCs 112(0)-112(3) to select streams of sampled values from sampler 111(1). Sampler 111(1) may provide the streams of sampled values to the ADCs 112(0)-112(3) during the single-channel operational mode.

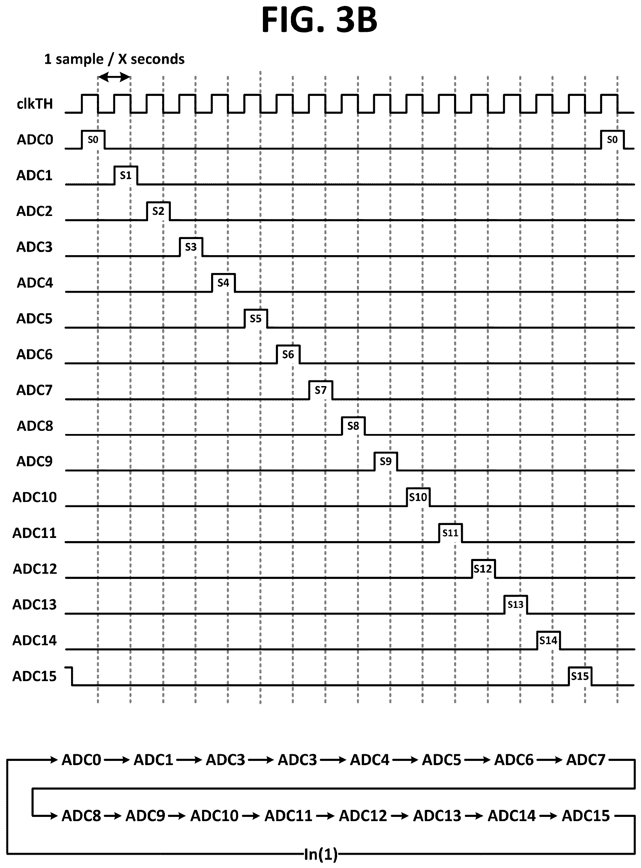

FIG. 3B illustrates a timing diagram for a single input channel at sample rate of:
1 sample / X seconds,
where "X" is a unit of time that is less than 1 second.
Sampler 111(1) may provide streams of sampled values to slices ADC0 through ADC15. During the single-channel operational mode, clock generator 115 may output slice selection signals S0-S15 that control the sequencing of sampled values across slices ADC0 through ADC15 as illustrated in the example of FIG. 3B.

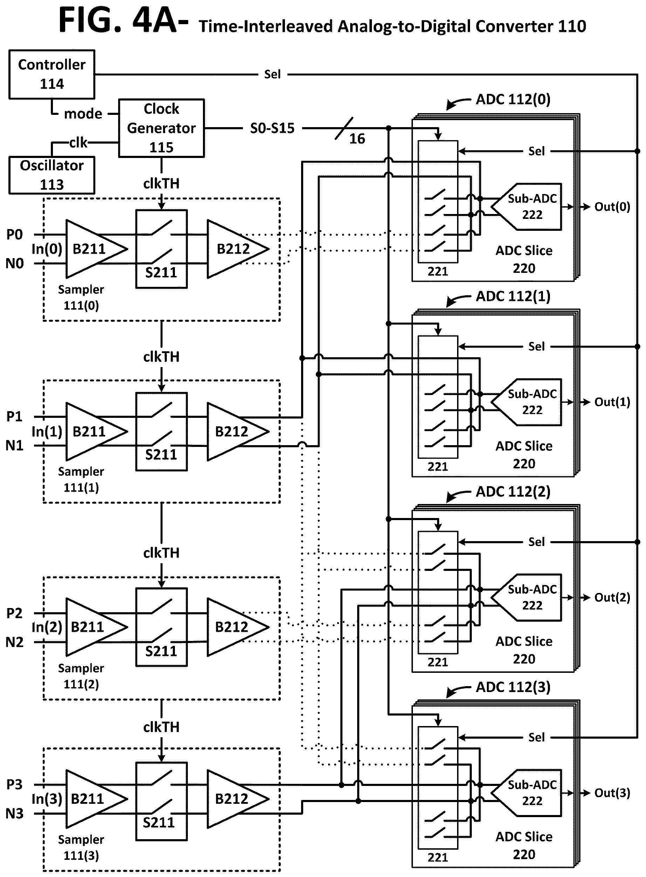

FIGS. 4A-4B illustrate an implementation of a dual-channel operational mode. The selection information may designate input channel 130(1) and input channel 130(3) as active input channels for the dual-channel operational mode. The dual-channel operational mode may exist as an alternative operating mode.

In the example of FIG. 4A, clock generator 115 may output selection signaling (sel) that causes multiplexer 221 in ADCs 112(0)-112(1) to select streams of sampled values from sampler 111(1) while causing multiplexer 221 in ADCs 112(2)-112(3) to select streams of sampled values from sampler 111(3). Sampler 111(1) may receive analog input signal In(1) from signal source 121 via input channel 130(1). Sampler 111(3) may receive analog input signal In(3) from signal source 123 via input channel 130(3). During the dual-channel operational mode, sampler 111(1) may provide the streams of sampled values to the ADCs 112(0)-112(2) and sampler 111(3) may provide the streams of sampled values to the ADCs 112(2)-112(3). Sampler 111(1) may provide streams of sampled values to slices ADC0 through ADC7 and sampler 111(3) may provide streams of sampled values to slices ADC8 through ADC15 as illustrated in the example of FIG. 4A.

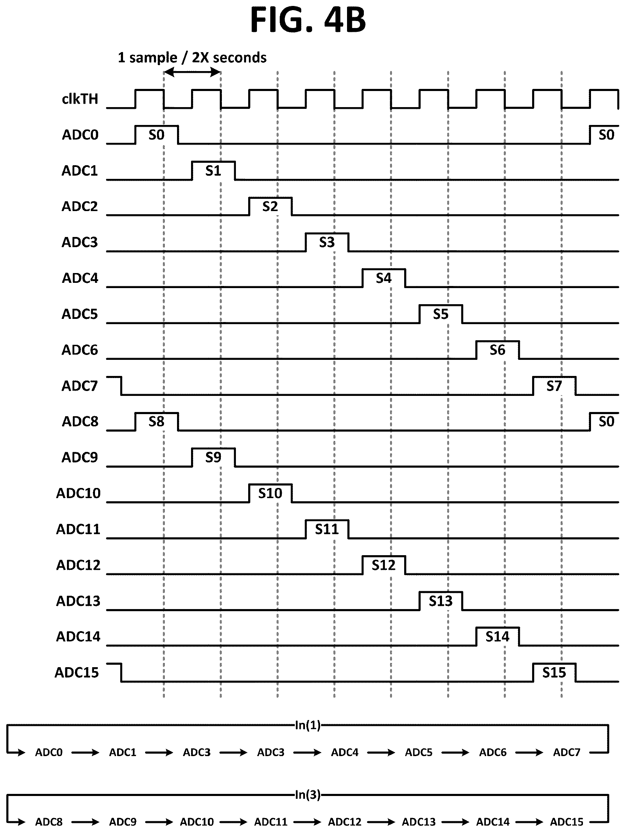

FIG. 4B illustrates a timing diagram for a dual input channel at sample rate of:
1 sample / 2X seconds,
where "X" is a unit of time that is less than 1 second.
During the dual-channel operational mode, clock generator 115 may output slice selection signals S0-S15 that control the sequencing of sampled values across slices ADC0 through ADC15 as illustrated in the example of FIG. 4B.

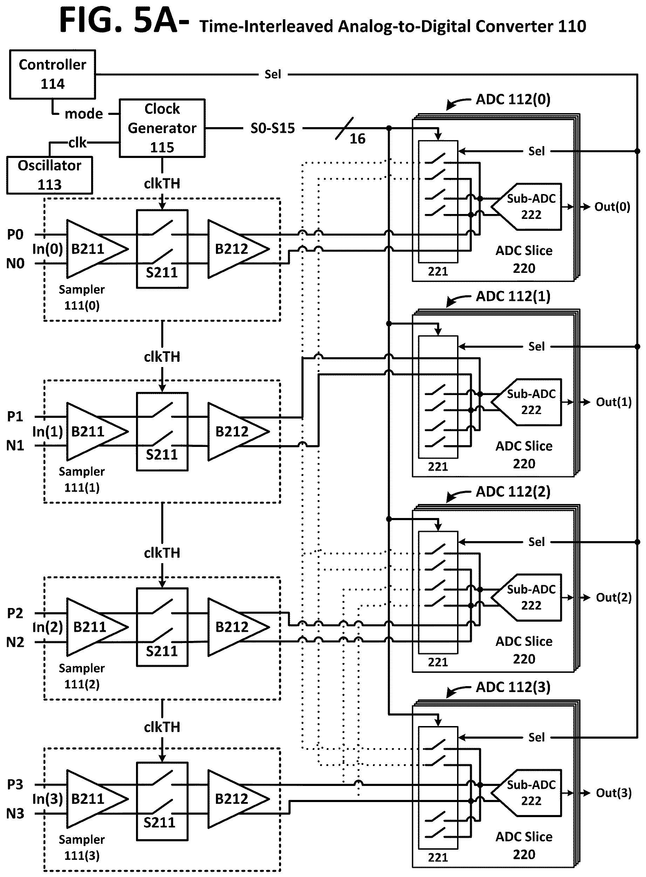

FIGS. 5A-5B illustrate an implementation of a quad-channel operational mode. The selection information designate input channels 130(1)-130(3) as active input channels for the quad-channel operational mode. A custom operating mode is the quad-channel operational mode. Sampler 111(0) may receive analog input signal In(0) from signal source 120 via input channel 130(0). Sampler 111(1) may receive analog input signal In(1) from signal source 121 via input channel 130(1). Sampler 111(2) may receive analog input signal In(2) from signal source 122 via input channel 130(2). Sampler 111(3) may receive analog input signal In(3) from signal source 123 via input channel 130(3).

In the example of FIG. 5A, clock generator 115 may output selection signaling (sel) that causes multiplexer 221 in ADC 112(0) to select streams of sampled values from sampler 111(0), multiplexer 221 in ADC 112(1) to select streams of sampled values from sampler 111(1), multiplexer 221 in ADC 112(2) to select streams of sampled values from sampler 111(2), and multiplexer 221 in ADC 112(3) to select streams of sampled values from sampler 111(3). Sampler 111(0) may provide streams of sampled values to slices ADC0 through ADC3, sampler 111(1) may provide streams of sampled values to slices ADC4 through ADC7, sampler 111(2) may provide streams of sampled values to slices ADC8 through ADC11 and sampler 111(3) may provide streams of sampled values to slices ADC12 through ADC15 as illustrated in the example of FIG. 5A.

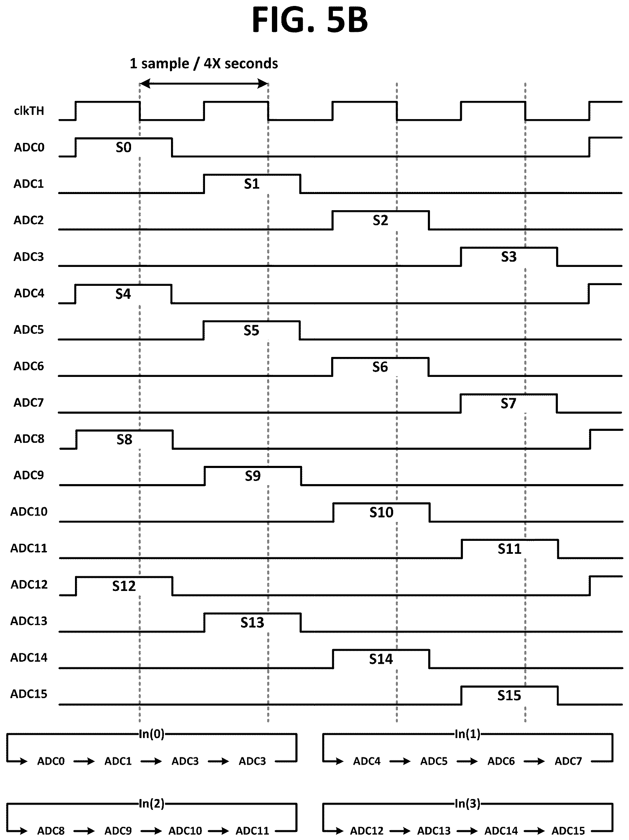

FIG. 5B illustrates a timing diagram for a quad input channel at sample rate of:
1 sample / 4X seconds,
where "X" is a unit of time that is less than 1 second.
During the quad-channel operational mode, clock generator 115 may output slice selection signals S0-S15 that control the sequencing of sampled values across slices ADC0 through ADC15 as illustrated in the example of FIG. 5B.

In some implementations, TI-ADC 110 may happen to be a system-on-chip. A system-on-chip is an integrated circuit that may combine an ADC 112(i) with samplers 111(i), oscillator 113, controller 114 and clock generator 115, all on a single chip. TI-ADC 110 is an apparatus.

Those skilled in the art will also appreciate the arrangement or interconnection of components such as "coupled," "connected," "on," "under," or similar wording allows for indirect connections, or intervening components or layers.

Certain operations of methods according to the technology, or of systems executing those methods, may be represented schematically in the figures or otherwise discussed herein. Unless otherwise specified or limited, representation in the figures of particular operations in particular spatial order may not necessarily require those operations to be executed in a particular sequence corresponding to the particular spatial order. Correspondingly, certain operations represented in the figures, or otherwise disclosed herein, may be executed in different orders than are expressly illustrated or described, as appropriate for particular examples of the technology. Further, in some examples, certain operations may be executed in parallel or partially in parallel, including by dedicated parallel processing devices, or separate computing devices configured to interoperate as part of a large system.

As used herein, unless otherwise limited or defined, "or" indicates a nonexclusive list of components or operations that may be present in any variety of combinations, rather than an exclusive list of components that may be present only as alternatives to each other. For example, a list of "A, B, or C" indicates options of: A; B; C; A and B; A and C; B and C; and A, B, and C.

Correspondingly, the term "or" as used herein is intended to indicate exclusive alternatives only when preceded by terms of exclusivity, such as, e.g., "either," "only one of," or "exactly one of." Further, a list preceded by "one or more" (and variations thereon) and including "or" to separate listed elements indicates options of one or more of any or all of the listed elements.

For example, the phrases "one or more of A, B, or C" and "at least one of A, B, or C" indicate options of: one or more A; one or more B; one or more C; one or more A and one or more B; one or more B and one or more C; one or more A and one or more C; and one or more of each of A, B, and C.

Similarly, a list preceded by "a plurality of" (and variations thereon) and including "or" to separate listed elements indicates options of multiple instances of any or all of the listed elements. For example, the phrases "a plurality of A, B, or C" and "two or more of A, B, or C" indicate options of: A and B; B and C; A and C; and A, B, and C.

In general, the term "or" as used herein only indicates exclusive alternatives (e.g., "one or the other but not both") when preceded by terms of exclusivity, such as, e.g., "either," "only one of," or "exactly one of."

Any mark, if referenced herein, may be common law or registered trademarks of third parties affiliated or unaffiliated with the applicant or the assignee. Use of these marks is by way of example and shall not be construed as descriptive or to limit the scope of disclosed or claimed embodiments to material associated only with such marks.

The articles "a," "an," and "the" are intended to include the plural forms as well, unless the context clearly indicates otherwise.

The terms "comprises," "includes," and "has" specify the presence of stated features, numbers, operations, members, elements, and/or combinations thereof, but do not preclude the presence or addition of one or more other features, numbers, operations, members, elements, and/or combinations thereof.

Throughout the application, ordinal numbers (e.g., first, second, third, and so forth.) may be used as an adjective for an element (i.e., any noun in the application).

Although terms such as "first," "second," and "third" may be used herein to describe various members, components, regions, layers, or sections, these members, components, regions, layers, or sections are not to be limited by these terms.

Rather, these terms are only used to distinguish one member, component, region, layer, or section from another member, component, region, layer, or section.

The use of ordinal numbers is not to imply or create any particular ordering of the elements nor to limit any element to being only a single element unless expressly disclosed, such as by the use of the terms "before," "after," "single," and other such terminology.

Rather, the use of ordinal numbers is to distinguish between the elements.

By way of an example, a first element is distinct from a second element, and the first element may encompass more than one element and succeed (or precede) the second element in an ordering of elements.

Thus, a first member, component, region, layer, or section referred to in examples described herein may also be referred to as a second member, component, region, layer, or section without departing from the teachings of the examples.

## Claims

1. An apparatus comprising:
a first sampler configured to produce, in response to sampling an analog input signal on a first input channel, a first stream of sampled values;
a first analog-to-digital converter configured to generate a first stream of digital data;
a second sampler configured to produce, in response to sampling an analog input signal on a second input channel, a second stream of sampled values;
a second analog-to-digital converter configured to convert, into a second stream of digital data, the second stream of sampled values; and
a clock generator configured to:
cause, in response to a mode instruction designating a custom operating mode, the first analog-to-digital converter to convert the first stream of sampled values into the first stream of digital data, and
cause, in response to the mode instruction designating a standard operating mode, the first analog-to-digital converter to convert the second stream of sampled values into the first stream of digital data.

2. The apparatus according to claim 1, wherein
the first stream of digital data is concurrent with the second stream of digital data.

3. The apparatus according to claim 1 or 2, wherein the clock generator is configured to receive the mode instruction from a controller.

4. The apparatus according to any one of the preceding claims, further comprising:
a third analog-to-digital converter configured to generate a third stream of digital data.

5. The apparatus according to claim 4, wherein
the third stream of digital data is concurrent with the first and second streams of digital data.

6. The apparatus according to claim 4 or 5, wherein
the clock generator is configured to cause, in response to the mode instruction designating the standard operating mode, the third analog-to-digital converter to convert the second stream of sampled values into the third stream of digital data.

7. The apparatus according to any one of the preceding claims 4 to 6, wherein the clock generator is configured to cause, in response to the mode instruction designating an alternative operating mode, the third analog-to-digital converter to convert a third stream of sampled values into the third stream of digital data;
wherein in particular the apparatus further comprises
a third sampler configured to produce, in response to sampling an analog input signal on a third input channel, the third stream of sampled values.

8. The apparatus according to any one of the preceding claims 4 to 7, further comprising:
a fourth analog-to-digital converter configured to generate a fourth stream of digital data.

9. The apparatus according to claim 8, wherein
the fourth stream of digital data is concurrent with the second and third streams of digital data.

10. The apparatus according to claim 8 or 9, wherein
the clock generator is configured to cause, in response to the mode instruction designating the standard operating mode, the fourth analogf-to-digital converter to convert the second stream of sampled values into the fourth stream of digital data.

11. The apparatus according to any one of the preceding claims 8 to 10, wherein the clock generator is configured to cause, in response to the mode instruction designating a baseline operating mode, the fourth analog-to-digital converter to convert a fourth stream of sampled values into the fourth stream of digital data;
wherein in particular the apparatus further comprises
a fourth sampler configured to produce, in response to sampling an analog input signal on a fourth input channel, the fourth stream of sampled values.

12. The apparatus according to any one of the preceding claims, wherein
an integrated circuit chip comprises the apparatus.

13. A method comprising:
sampling, by a first sampler, an analog input signal on a first input channel to produces a first stream of sampled values;
generating, by a first analog-to-digital converter, a first stream of digital data;
sampling, by a second sampler, an analog input signal on a second input channel to produce a second stream of sampled values;
converting, by a second analog-to-digital converter, the second stream of sampled values into a second stream of digital data;
causing, by a clock generator in response to a mode instruction designating a custom operating mode, the first analog-to-digital converter to convert the first stream of sampled values into the first stream of digital data; and
causing, by the clock generator in response to the mode instruction designating a standard operating mode, the first analog-to-digital converter to convert the second stream of sampled values into the first stream of digital data.

14. The method of claim 13, wherein
the first stream of digital data is concurrent with the second stream of digital data; and/or wherein
the method further comprises receiving, by the clock generator, the mode instruction from a controller.

15. The method of claim 13 or 14, further comprising:
generating, by a third analog-to-digital converter, a third stream of digital data; wherein in particular the method further comprises
causing, by the clock generator in response to the mode instruction designating an alternative operating mode, the third analog-to-digital converter to convert a third stream of sampled values into the third stream of digital data;
wherein further in particular the method further comprises
producing, by a third sampler in response to sampling an analog input signal on a third input channel, the third stream of sampled values.
